# EUROPÄISCHE PATENTSCHRIFT

(11) **EP 1 710 592 B1**
(45) Veröffentlichungstag und Bekanntmachung des Hinweises auf die Patenterteilung: **30.03.2011**
(21) Anmeldenummer: 06002538.4
(22) Anmeldetag: 08.02.2006
(51) Int. Cl.: G01R 31/02, G01R 31/12

(54) **Anordnung zur Erfassung eines Störlichtbogens**
Device for detecting an arc
Dispositif pour détecter un arc

(30) Priorität: 08.04.2005 DE 102005016104
(43) Veröffentlichungstag der Anmeldung: 11.10.2006
(73) Patentinhaber: Eaton Industries GmbH, 53115 Bonn (DE)
(72) Erfinder: Schumacher, Andreas, 53547 Dattenberg (DE)

(56) Entgegenhaltungen:
- WO-A-02/21657
- CH-A5- 676 174
- DE-A1- 3 534 176
- DE-A1- 4 331 716

## Beschreibung

Die Erfindung betrifft eine Anordnung zur Erfassung eines Störlichtbogens, in einer elektrischen Anlage, insbesondere in einer Verteiler- oder Schaltanlage.

Das Auftreten von Lichtbögen in einer elektrischen Anlage durch einen Schadensfall hat in Regel die Zerstörung der Anlage zur Folge. Es sind daher schon Maßnahmen und Anordnungen beschrieben worden, die eingesetzt werden, um schädliche Folgen von Lichtbögen zu begrenzen.

Wesentlich zur Verminderung des Problems ist, das Auftreten eines Lichtbogens opto-elektronisch zu erfassen und nach Auftreten eines Sensorsignals mittels einer Elektronik ein Schaltsignal an einen Schalter zu geben, beispielsweise an einen Leistungsschalter, der die Verteiler- oder Schaltanlage vom Netz trennt. Damit erlischt der Lichtbogen.

Eine sehr wirkungsvolle Maßnahme besteht darin, nach Erfassen des Störlichtbogens die Spannungsversorgung der Verteiler- oder Schaltanlage kurzzuschließen. Hierzu sind Kurzschließer vorgeschlagen worden (DE 197 46 564 A1). Mit einer solchen Schaltmaßnahme kann innerhalb von ein oder zwei Millisekunden dem Lichtbogen die treibende elektrische Energie vollständig entzogen werden, wodurch der Lichtbogen erlischt.

Zur Detektion eines Lichtbogens sind als Punkt- oder Liniensensoren schon verschiedene optische Detektoren vorgeschlagen worden. Beispielsweise ist in der US 4,418,338 ein Liniensensor beschrieben, bei dem das Licht durch den transparenten Mantel in den Kern der Lichtleitfaser eintritt. Das eingedrungene Licht dient als Detektions- oder Meldesignal, welches über opto-elektronische Mittel erfasst wird. Der Erfassungsbereich der Lichtleitfaser ist somit rundum transparent ausgebildet, so dass die Lichtleitfaser aus dem gesamten zylindrischen Raumbereich rundum Licht empfängt.

Geeignete Lichtwellenleiter sind seit langem bekannt. Kern und Mantel bestehen bei üblichen Fasern beispielsweise aus Glas, Quarz oder Kunststoff. Auf der Tagung 'EFOC/LAN/85' (19.-21.06.1985) in Montreux wurde von W. B. Beck das Paper 'Hard Clad Silica Fibers for Data and Power Transmission' vorgetragen (pp. 146-151). Darin sind Lichtwellenleiter mit coating aus Tefzel® beschrieben. Tefzel® ist ein klarer Kunststoff aus Ethylen-Tetrafluoroethylen-Copolymer, welcher mit zunehmender Dicke zunehmend opak wird. Die in dem Paper genannten coating-Schichten betragen 10 bis 20 µm abhängig auch vom Durchmesser der Faser des Lichtwellenleiters. In dünnen Schichten hat Tefzel® eine optische Transparenz von 96 %.

Eine Anforderung an die Sensorik ist, dass sie mit zunehmender Spannungsebene umso zuverlässiger sein muss, weil mit Zunahme der Spannung die Lichtbogenenergie und damit das Schadensrisiko zunehmen.

Eine andere Anforderung besteht darin, dass im geringeren Leistungsbereich einer Schaltanlage, in dem ein Störlichtbogen auch mit geringerer Stromstärke brennt, die Sensorik zwischen realen Störlichtbögen und sonstigen Lichtemissionen differenzieren können muss. Da in Schaltanlagen weitere Schaltorgane vorhanden sind, und Schaltorgane im Schaltvorgang selbst einen Lichtbogen erzeugen, sollen solche Schaltlichtbögen nicht zum Auslösen der Sensorik führen. Weiter kommt der Sachverhalt hinzu, dass konventionelle Leistungsschalter auf das Abschalten von Kurzschlüssen abgestellt sind. Störlichtbögen mit hoher Stromstärke werden von Leistungsschaltern korrekt erfasst und führen zum Auslösen des Leistungsschalters. Demgegenüber wird ein Störlichtbogen mit niedriger Stromstärke von einem Leistungsschalter nicht oder nur zeitverzögert abgeschaltet, weil ein niedrigere Stromstärkenbereich in der Größenordnung von Anlaufströmen liegt und Anlaufvorgänge naturgemäß nicht unterbrochen werden dürfen. Da ein Störlichtbogen einen ohmschen Widerstand hat, liegt die Stromstärke des Störlichtbogens in der Regel unterhalb von 70 % der prospektierten Kurzschlussleistung.

Ein Nachteil des Standes der Technik ist die Störanfälligkeit bei Vorhandensein von Fremdlicht. Bekannt ist, dass Erfassungsanordnungen bei Eindringen von Licht bei Schweißarbeiten oder von Sonnenlicht die Abschaltung der Anlage auslösen. Um diesem Problem zu begegnen, muss ein Kompromiss zwischen Auswerteempfindlichkeit des optischen Nutzsignals und der elektronischen Verstärkung des Nutzsignals gefunden und eingestellt werden. Eine zu geringe Verstärkung führt zur Fehlfunktion (Nichtabschalten) bei relativ schwach leuchtenden Störlichtbögen. Eine hohe Verstärkung des optischen Nutzsignals führt eher zur Erfassung von Fremdlicht und damit zur Fehlabschaltung ohne Vorhandensein eines Störlichtbogens. Im Zusammenhang mit der Erhöhung der Verstärkung tritt der Effekt hinzu, dass die Elektronik empfindlicher wird gegen elektromagnetische Störeinflüsse. Fehlabschaltungen können daher auch ohne Fremdlicht auftreten, wenn die EMV-Stabilität der Elektronik überansprucht oder 'ausgereizt' wird.

Es ist bekannt, eine Vorrichtung zur optischen Erkennung und Abschaltung eines Störlichtbogens mit einem Stromerfassungssensor zu kombinieren. Nur bei dem gleichzeitigen Auftreten eines optischen und eines elektrischen Signals wird die Vorrichtung zum Abschalten angesteuert. Die Verwendung eines Stromerfassungssensors vermindert die Wahrscheinlichkeit einer fehlerhaften Detektion. Wie aus dem Dargestellten klar sein sollte, lässt sich die Erfassungssicherheit nicht einfach dadurch verbessern, dass der Stromerfassungssensor zu höherer Empfindlichkeit oder auf kleinere Erfassungsströme eingestellt wird, da kleinere Ströme sowohl Nutzströme als auch Fehlerströme sein können.

Eine ältere Erfassungsanordnung (DE 3534176 A1) zeigt einen Lichtwellenleiter für radial in ihn einstrahlendes Licht. Der undurchsichtige Mantel des Lichtwellenleiters ist so präpariert, dass ein Fenster als transparente Öffnung ausgebildet ist. Die Größe der Öffnung bestimmt die Menge eintretender Strahlung.

Es ist eine weitere Erfassungsanordnung bekannt (WO 02-21657 A1), bei der die Lichtleitfaser zwei unterschiedliche Bereiche aufweist. In einem ersten Bereich ist die Lichtleitfaser mit einem opaken Medium umgeben (jacketed section) und in einem zweiten Bereich hat das umgebende Medium volle Transparenz (clear section) für radial in die Lichtleitfaser einstrahlendes Licht. In beiden vorgenannten Erfassungsanordnungen soll das optische Nutzsignal maximal ausgenutzt werden.

Zur Erhöhung der optischen Empfindlichkeit wurde schon vorgeschlagen, die Ummantelung der Lichtleitfaser farbig zu tönen (DE 43 31 716 A1). In der genannten Schrift werden unterschiedliche Maßnahmen zu Verbesserung der Empfindlichkeit ausführlich diskutiert. Die Einfärbung der Ummantelung (blau oder grün) hat eine wellenlängenabhängige Filterwirkung, die zur Erhöhung des Nutzpegel-Störpegel-Abstandes beitragen soll. Diese Maßnahmen zeigen jedoch nicht immer die gesuchten Vorteile.

Es ist die Aufgabe der Erfindung, die Stabilität und Wirksamkeit einer Erfassungsanordnung noch weiter zu verbessern.

Die Lösung findet sich in den Merkmalen des Hauptanspruchs. Weiterführungen Ausbildungen der Erfindung werden in den Unteransprüchen dargestellt.

Der Kern der Erfindung besteht darin, dass das Aufnahmevermögen auf einen Wert unter 70 % des maximal möglichen Aufnahmevermögens reduziert ist, wobei das mögliche optische Aufnahmevermögen durch Aufbau der Lichtleitfaser und ihres coatings bestimmt ist.

Vorzugsweise ist daher vorgesehen, einen Lichtwellenleiter mit coating aus Tefzel® oder Teflon® mit einer Dicke von 10 bis 20 µm einzusetzen. Solche coating-Materialien haben noch den Vorteil, dass sie den Durchtritt von Wasser verhindern. Bekanntermaßen sind Wassermoleküle in einer Lichtleitfaser Ursache für eine Erhöhung der Dämpfung.

Die Reduzierung kann dadurch erfolgen, dass das Aufnahmevermögen durch eine gezielte Abschattung in Teilen des umgebenden Raumbereichs erfolgt. Mit Abschattung ist gemeint, dass der Zutritt von Licht aus allen Wellenlängenbereichen blockiert ist. Dies ist beispielsweise dadurch zu erreichen, dass die Lichtleitfaser im Erfassungsbereich mit einer für Störlichtbogenlicht teiltransparenten, zylindrischen Abdeckung umgeben ist.

Die Abschattung kann herunter bis 30 % des maximal möglichen Aufnahmevermögens vorgenommen sein. Vorzugsweise kann die Abschattung bei etwa 50 % liegen. Im nichttransparenten Bereich ("Schwarzanteil") soll kein Licht in den Kern der LWL eindringen. Die Erfindung geht somit den Weg, die optische Empfindlichkeit nicht durch Beschränkung auf bestimmte Wellenlängenbereiche des Störlichtbogenlichts zu erhöhen, sondern generell durch Verminderung der Einstrahlungsintensität.

Der Vorteil der Erfindung liegt darin, dass mit Absenkung der Empfindlichkeit des optischen (nicht des elektrischen) Kanals der Erfassungseinrichtung die optische Eigenschaft der Sensorik zu der elektronischen Eigenschaft besser aufeinander abstimmbar ist. Insbesondere durch Einsatz von Lichtleitern mit großem Durchmesser aus Quarz- oder Kunststoff-Fasern lässt sich die Menge des aufzunehmenden Lichts vergrößern. Eine Verringerung der Oberfläche des Sensors ist daher möglich, ohne den Verstärkungsfaktor der Elektronik (im "elektrischen Kanal") zu erhöhen. Mit der Erfindung kann somit ein größerer Störabstand von Störpegel zu Nutzsignal ausgenutzt werden.

Ohne Änderung der elektronischen Verstärkung wird das System unempfindlicher gegen Fremdlicht. Bei Vermeidung der Erhöhung der elektronischen Verstärkung lässt sich die elektromagnetische Störanfälligkeit des Systems begrenzen.

Ein weiterer Vorteil der Erfindung liegt darin, dass ein als Abdeckung ausgebildetes Röhrchen als Schutz und Stütze der mechanisch empfindlichen Lichtleitfaser dient und das Montieren des optischen Sensors dadurch erleichtert wird.

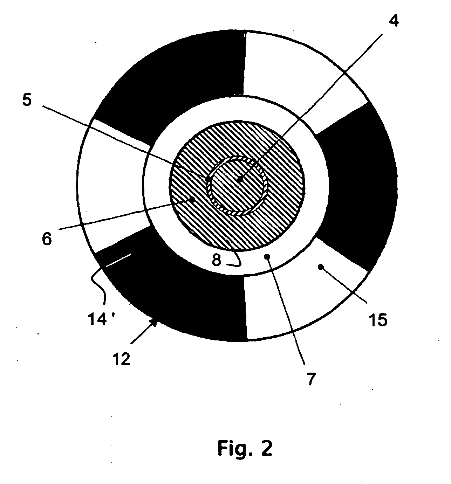

Die Abschattung des zylindrischen Raumwinkels rings um die Lichtleitfaser wird mit einer Hülle vorgenommen, die als Schlauch oder Röhrchen ausgebildet sein kann. Die Lichtleitfaser liegt lose in dieser Hülle (vgl. Fig. 2); es sei denn, die Hülle wird als Schrumpfschlauch aufgebracht.

Eine weitere vorzugsweise Ausbildung besteht darin, dass die teiltransparente Abdeckung das coating (Beschichtung) der Lichtleitfaser selbst ist. Hierbei wird über dem Mantel (cladding) der Faser, welcher aus optischen Gründen transparent ist (nämlich aus optischem Material mit einem kleineren Brechungsindex als der Faserkern), das coating aufgebracht. Das coating hat teiltransparente Bereiche. Das coating kann beispielsweise aus Teflon® oder Tefzel® bestehen.

Als weitere Ausgestaltungen der Erfindungen wird erwähnt:

Das Material der teiltransparenten Abdeckung ist vorzugsweise transparenter Kunststoff. Als Material hat sich beispielsweise PVDF (Kynar®) oder Acrylat als geeignet herausgestellt.

In der Abdeckung sind transparente und nichttransparente Bereiche ausgebildet.

Der nichttransparente Bereich ist als mindestens ein Streifen in Längsrichtung in der Abdeckung ausgebildet, wobei der andere, transparente Bereich (abhängig vom Material) maximale optische Durchlässigkeit hat. Es können mehrere nichttransparente Streifen (neben transparenten Streifen) in Längsrichtung in oder auf der Abdeckung ausgebildet sein. Die nichttransparenten Streifen können parallel (zur Lichtleitfaser) in Längsrichtung oder sich kreuzend verlaufen. Der nichttransparente Bereich kann auch als Flecken oder Punkte auf oder in der Abdeckung ausgebildet sein.

Die Abdeckung kann im transparenten Bereich farbig eingefärbt sein. Acrylat ist ein Stoff, der leicht einfärbbar ist. Starke und damit sehr heiße Störlichtbögen strahlen auch im UV-Licht, so dass vorzugsweise Abdeckungen auch transparent für UV-Licht sein sollten.

Weiterhin ist eine blaue Einfärbung günstig, wodurch rot stärker ausgefiltert wird. Solche Einfärbungen würden vornehmlich als Filter gegen langwelliges Licht wirken, welches von Fremdlichtquellen stammt, wie Glühlampenlicht oder dergleichen. Fremdlicht darf nicht zu Fehlauslösungen führen. Im Störlichtbogenlicht treten besonders Spektrallinien des Kupfers auf, die im grünen Bereich liegen. Falls die Einfärbung blau oder grün ist, ist die Filterwirkung in diesem Spektralbereich gering und somit vorteilhaft.

Der Einsatz der Erfassungsanordnung kann sein in elektrischen Schalt- oder Verteileranlagen, wobei vorzugsweise als Spannungsebene Niederspannung oder Mittelspannung infrage kommen. Eine Verteileranlage kann eine Trafostation oder ein Stromschienenverteiler oder dergleichen sein.

Die Stärke der Lichtbogenströme hängt ab von der Größenordnung der möglichen Kurzschlussströme. Typische Anwendungsfälle sind Systeme im Niederspannungsbereich, wo Kurzschlussströme bis 100 kA möglich sind. Wegen der höheren Spannung in Mittelspannungsanlagen sind dort in der Regel nicht so starke Ströme zu erwarten. Generell wird eine untere Erfassungsschwelle elektronisch fest eingestellt. Eine solche Schwelle könnte beispielsweise bei 6 kA liegen.

Die Hülle kann auch als Gewebeschlauch ausgebildet sein, welcher in seinem Innern die Lichtleitfaser beherbergt. Gewebeschläuche sind bekannt. Sie haben den Vorteil, dass sie durch Strecken in ihrem Durchmesser verkleinerbar sind und dadurch beispielsweise auch auf ein voll-transparentes Kunststoffröhrchen oder direkt auf eine Lichtleitfaser aufziehbar ist. Der Schlauch müsste aus nichttransparentem Material gewebt sein, wobei das Gewebe ein Netz bildet, welches mindestens 30 % der Oberfläche abdeckt.

Die Erfindung wird in zwei Figuren dargestellt. Es zeigen
Fig. 1 schematisch eine Ausführungsform einer Erfassungsanordnung und
Fig. 2 einen Schnitt durch eine Lichtleitfaser mit Abdeckung.

Als optischer Liniensensor ist eine Lichtleitfaser 8 dargestellt, die in einem ersten Längenabschnitt 22 eine nichttransparente Ummantelung 10 (coating) hat. In diesem Längenabschnitt kann kein Licht in das Innere eintreten; der Abschnitt dient nicht der Lichtbogenerfassung. Ein zweiter Längenabschnitt 20 dient der Aufnahme von radial einstrahlendem Licht. Dieser Abschnitt wird im folgenden als Erfassungsabschnitt bezeichnet. Auf der Länge einer Lichtleitfaser können mehrere Erfassungsabschnitte vorhanden sein, die hintereinander von mehreren nichttransparenten Bereichen voneinander getrennt sein können.

Gemäß Erfindung ist vorgesehen, dass im Erfassungsabschnitt 20 der volle zylindrische Raumwinkel, der von der Achse der Lichtleitfaser aus gezählt wird, in Bereiche unterteilt ist, in denen das optische Aufnahmevermögen für alle Wellenlängen des zu erfassenden Lichts reduziert ist. Die Reduzierung des Aufnahmevermögens erfolgt durch Abschattung von Teilen des zylindrischen Raumwinkels.

**Tabelle: Lichtaufnahmevermögen aus zylindrischem Raumwinkel**

| Lichtleitfaser mit transparentem coating ohne Abschattung | Hülle aus geschwärztem Röhrchen | teiltransparente Hülle als Röhrchen (je nach Ausführung) |
|---|---|---|
| 100% | 0% | 30 bis 70 % |

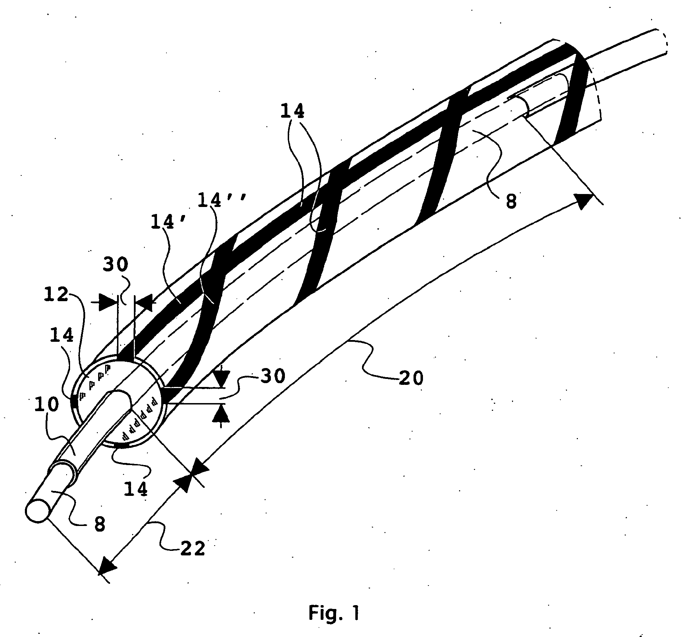

Nach der in der Fig. 1 dargestellten Ausführungsform liegt die Lichtleitfaser relativ lose in einem als zylindrische Hülle 12 ausgebildeten Röhrchen oder Schlauch. Das Material des Röhrchens kann vorzugsweise Kunststoff sein, wobei dieser mehr oder weniger flexibel sein kann. Die nichttransparenten Bereiche der Hülle können in die Masse des Röhrchens, beispielsweise eingebracht in einem Extrusionsvorgang oder auf der Oberfläche des Röhrchens aufgetragen sein.

Die nichttransparenten Bereiche können als Streifen oder Flecken geformt sein. In der Regel sind mehrere Streifen (14', 14") vorhanden, die parallel oder gewendelt, sich kreuzend verlaufen können. Der von den Streifen abgedeckte Bereich oder Raumwinkel wird in Fig. 1 mit dem Bezugszeichen 30 bezeichnet. Gemäß Erfindung sollen die nichttransparenten Bereiche mindestens 30 %, vorzugsweise 50 % der zylindrischen Oberfläche der Hülle ausmachen.

Die Fig. 2 zeigt einen - nicht unbedingt maßstäblichen - Schnitt durch eine Lichtleitfaser 8 mit einer als Röhrchen 12 ausgebildeten Abdeckung. Im Röhrchen sind drei nichttransparente 14' und drei transparente Streifen 15 ausgebildet. Der nichttransparente Anteil ("Schwarzanteil") beträgt nach der Figur 55 %. Zu erkennen sind der Kern 4, den Mantel (Cladding) 5 und coating 6 der Lichtleitfaser 8. Zwischen Röhrchen 12 und Lichtleitfaser befindet sich Luft 7. Die Lichtleitfaser liegt somit lose in dem Röhrchen.

Die Abmessungen in den Figuren sind nur schematisch zu verstehen. Konventionelle Lichtleitfasern (z.B. für den optischen Datentransfer) haben einen Kern-Durchmesser unter 100 µm. Bei anderen Lichtleitfasern kann der Kern dicker sein: 150 bis 200 µm. Somit ist die Lichtaufnahmequalität für die Verwendung als Sensor bei der vorgeschlagenen Erfindung größer. Der Innendurchmesser der Hülle ist entsprechend (je nach Lichtleitertyp) größer. Die weiteren Abmessungen sind: Dicke des Mantels (cladding) etwa 15 µm; Dicke des rundum transparenten coatings ca. 135 µm, Gesamtdurchmesser der Lichtleitfaser ca. 500 µm; Luftschicht ca. 100 µm; das Röhrchen hat eine Wanddicke von 250 µm, somit Außendurchmesser des Röhrchens ca. 1200 µm.

### Bezugszeichen

- 4: Kern
- 5: Mantel (cladding)
- 6, 10: coating
- 7: Luftschicht
- 8: Lichtleitfaser
- 10, 12: Abdeckung
- 12: Röhrchen
- 14', 14": nichttransparente Streifen
- 15: transparenter Bereich
- 20: Erfassungsbereich
- 22: Nichterfassungsbereich
- 30: Raumwinkel der Abschattung eines Streifens

## Patentansprüche

1. Anordnung zur Erfassung eines Störlichtbogens in einer elektrischen Anlage, insbesondere in einer Verteiler- oder Schaltanlage,
• wobei die Erfassungsanordnung eine Lichtleitfaser (8) und Elektronik umfasst, und die Lichtleitfaser (8) zur Erfassung des von einem Störlichtbogen ausgestrahlten Lichts dient,
• wobei in mindestes einem als Erfassungsbereich (20) ausgebildeten Längenabschnitt (22) der Lichtleitfaser (8) das Licht radial durch eine transparente, zylindrische Abdeckung (6) in den Kern (4) der Lichtleitfaser dringt,
• und das Licht als Sensorsignal von der Elektronik verarbeitet wird,
• wobei die Elektronik nach Auftreten eines Sensorsignals zur Ausgabe eines Schaltsignals an einen Schalter ausgestaltet ist, der zur Abschaltung der den Lichtbogen treibenden Spannung geeignet ist, und
• die Erfassungsanordnung derart ausgebildet ist, dass die Abdeckung (10,12) in dem mindestes einem Erfassungsbereich (20) eine reduzierte Transparenz aufweist,
**dadurch gekennzeichnet, dass** die reduzierte Transparenz des mindestens einen Längenabschnitts (15, 22) **dadurch** hergestellt ist, dass in der Abdeckung (10,12) in Längsrichtung der Lichtleitfaser (8) ausgebildete nicht-transparente Streifen (14', 14'') oder nicht-transparente Flecken vorhanden sind, und dass die nicht-transparenten Bereiche (14', 14") mindestens 30 % einer Oberfläche der zylindrischen Abdeckung (6) ausmachen.

2. Anordnung nach Anspruch 1, **dadurch gekennzeichnet, dass** die nicht-transparenten Bereiche (14', 14") mindestens 50 % der Oberfläche der zylindrischen Abdeckung (6) ausmachen.

3. Anordnung nach einem der vorhergehenden Ansprüche, **dadurch gekennzeichnet, dass** die Abdeckung (10, 12) als coating (6, 10) der Lichtleitfaser (8) ausgebildet ist.

4. Anordnung nach einem der Ansprüche 1 bis 2, **dadurch gekennzeichnet, dass** die Abdeckung als Röhrchen (12) ausgebildet ist, welches in seinem Innern die Lichtleitfaser (8) beherbergt.

5. Anordnung nach einem der vorhergehenden Ansprüche, **dadurch gekennzeichnet, dass** der oder die nichttransparente/n Streifen (14', 14") parallel zur Längsrichtung der Lichtleitfaser (8) ausgebildet ist/sind.

6. Anordnung nach einem der Ansprüche 1 bis 4, **dadurch gekennzeichnet, dass** mehrere nichttransparente Streifen (14") sich kreuzend ausgebildet sind.

7. Anordnung nach einem der vorhergehenden Ansprüche, **dadurch gekennzeichnet, dass** die Abdeckung in einem als Erfassungsbereich (15, 20) ausgebildeten Längenabschnitt (22) farbig eingefärbt ist.

8. Anordnung nach Anspruch 4, **dadurch gekennzeichnet, dass** das Röhrchen (12) als Gewebeschlauch ausgebildet ist, welcher in seinem Innern die Lichtleitfaser (8) beherbergt und dass in dem Schlauch ein nichttransparentes Gewebenetz vorhanden ist.

## Claims

1. An arrangement for detecting a fault arc in an electrical installation, in particular in a distribution or switching unit,
- the detection arrangement comprising an optical fibre (8) and electronics, and the optical fibre (8) serving to detect the light emitted by a fault arc,
- the light penetrating radially through a transparent cylindrical cover (6) into the core (4) of the optical fibre in at least one length section (22) of the optical fibre (8) which is formed as a detection region (20),
- and the light being processed as a sensor signal by the electronics,
- the electronics, after a sensor signal has occurred, being configured to emit a switching signal to a switch which is suitable for switching off the voltage generating the arc, and
- the detection arrangement being formed such that the cover (10, 12) in the at least one detection region (20) has a reduced transparency,
**characterised in that** the reduced transparency of the at least one length section (15, 22) is produced by non-transparent strips (14', 14") or non-transparent spots formed in the longitudinal direction of the optical fibre (8) being present in the cover (10, 12), and **in that** the non-transparent regions (14', 14") make up at least 30% of a surface of the cylindrical cover (6).

2. An arrangement according to Claim 1, **characterised in that** the non-transparent regions (14', 14") make up at least 50% of the surface of the cylindrical cover (6).

3. An arrangement according to one of the preceding claims, **characterised in that** the cover (10, 12) is formed as a coating (6, 10) of the optical fibre (8).

4. An arrangement according to one of Claims 1 to 2, **characterised in that** the cover is formed as a small tube (12) which houses the optical fibre (8) in its interior.

5. An arrangement according to one of the preceding claims, **characterised in that** the non-transparent strip or strips (14', 14") is/are formed parallel to the longitudinal direction of the optical fibre (8).

6. An arrangement according to one of Claims 1 to 4, **characterised in that** a plurality of non-transparent strips (14") are formed crossing one another.

7. An arrangement according to one of the preceding claims, **characterised in that** the cover is coloured in a length section (22) formed as a detection region (15, 20).

8. An arrangement according to Claim 4, **characterised in that** the small tube (12) is formed as a fabric tube which houses the optical fibre (8) in its interior, and **in that** a non-transparent fabric net is present in the tube.

## Revendications

1. Dispositif de détection d'un arc électrique dans une installation électrique, notamment dans une installation de distribution ou de couplage,
- le dispositif de détection comprenant une fibre optique (8) et de l'électronique et la fibre optique (8) servant à détecter la lumière émise par un arc électrique,
- la lumière pénétrant radialement au coeur (4) de la fibre optique à travers une gaine cylindrique transparente (6) dans au moins une section longitudinale (22) de la fibre optique (8) exécutée en tant que zone de détection (20)
- et la lumière étant traitée en tant que signal de détection par l'électronique,
- l'électronique étant réalisée pour envoyer, après apparition d'un signal de détection, un signal de commutation à un commutateur qui est adapté pour couper la tension qui provoque l'arc et
- le dispositif de détection est exécuté de manière à ce que la gaine (10, 12) présente une transparence réduite dans la au moins une zone de détection (20),
**caractérisé par le fait que** la transparence réduite de la au moins une section longitudinale (15, 22) est obtenue en prévoyant des bandes non transparentes (14', 14") ou tâches non transparentes formées dans la gaine (10, 12) dans la direction longitudinale de la fibre optique (8) et en faisant en sorte que les zones non transparentes (14', 14") représentent au moins 30% d'une surface de la gaine cylindrique (6).

2. Dispositif selon la revendication 1, **caractérisé par le fait que** les zones non transparentes (14', 14") représentent au moins 50% de la surface de la gaine cylindrique (6).

3. Dispositif selon l'une des revendications précédentes, **caractérisé par le fait que** la gaine (10, 12) est exécutée en tant que revêtement (6, 10) de la fibre optique (8).

4. Dispositif selon l'une des revendications 1 à 2, **caractérisé par le fait que** la gaine est exécutée en tant qu'élément tubulaire (12) dont l'intérieur abrite la fibre optique (8).

5. Dispositif selon l'une des revendications précédentes, **caractérisé par le fait que** la ou les bande/s non transparente/s (14', 14") est/sont réalisée/s parallèlement à la direction longitudinale de la fibre optique (8).

6. Dispositif selon l'une des revendications 1 à 4, **caractérisé par le fait que** plusieurs bandes non transparentes (14") se croisent.

7. Dispositif selon l'une des revendications précédentes, **caractérisé par le fait que** la gaine présente une coloration dans une section longitudinale (22) exécutée en tant que zone de détection (15, 20).

8. Dispositif selon la revendication 4, **caractérisé par le fait que** l'élément tubulaire (12) est exécuté en tant que tuyau tissé dont l'intérieur abrite la fibre optique (8) et **par le fait que** le tuyau comporte un réseau tissé non transparent.
